(19) Europäisches Patentamt / European Patent Office / Office européen des brevets

(11) **EP 2 395 557 A2**

(12) **EUROPEAN PATENT APPLICATION**

(43) Date of publication:
**14.12.2011 Bulletin 2011/50**

(51) Int Cl.:
*H01L 31/042* $^{(2006.01)}$   *H01L 31/052* $^{(2006.01)}$

(21) Application number: **11157854.8**

(22) Date of filing: **11.03.2011**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **08.06.2010 TW 099118568**

(71) Applicants:
• **DelSolar (Wujiang) Ltd.**
  **Wujiang City, Jiangsu 215200 (CN)**

• **DelSolar Co., Ltd.**
  **Hsinchu 30076 (TW)**

(72) Inventor: **Lin, Hung-Yang**
  **235, New Taipei City (TW)**

(74) Representative: **Becker Kurig Straus**
  **Patentanwälte**
  **Bavariastrasse 7**
  **80336 München (DE)**

(54) **Solar cell module and method of fabricating the same**

(57)     A solar cell module (36) has a hermetic chamber (34) in the cover plate (10). The hermetic chamber (34) is disposed on the non-cell region (102) of the solar cell module (36) to direct light toward the cell region (100) through total reflection. The hermetic chamber (34) includes a V-shaped groove (18) embedded in the cover plate (10) of the solar cell module (36), and the V-shaped groove (18) is sealed with a sealing layer (22) so as to make the hermetic chamber an empty space which does not allow unwanted substances to get in or out.

FIG. 5

EP 2 395 557 A2

**Description**

The invention relates to a solar cell module capable of improved conversion efficiency and a method of making the same according to the pre-characterizing clauses of claims 1 and 10, respectively.

In the technical field of solar energy conversion, the most commonly utilized device for conversion of radiant energy into electric power is known as the solar cell and consists of the juxtaposition of materials of different electrical conductivities to form a rectifying junction which will result in the generation of current in response to exposure to solar radiation. Typically, most solar cells have a single P/N junction formed from oppositely doped semi-conductor material.

Industry practice is usually to combine a plurality of cells so as to form a physically integrated module with a correspondingly greater power output. Several solar modules may be connected together to form a larger array with a correspondingly greater power output.

To provide better protection of the individual cells and their interconnections, it has been common practice for such modules to have laminated structures. These laminated structures consist of cells, adhesive layers and front and back protective sheets. Solar cells are encapsulated by the protective sheets with adhesive layers disposed between the solar cells and the protective sheets. The lamination process of the solar cells, adhesive layers and front and back protective sheets are generally performed under a vacuum environment, and pressing the cells, adhesive layers and front and back protective sheets at a laminating temperature commonly higher than 135°C to form a laminated structure.

Usually the front and back protective sheets are totally overlapped with each other. The region on the front and back protective sheets without cells is defined as a non-cell region; the region having at least a cell on the front and back protective sheets is defined as a cell region. When cells are arrayed in a module, adjacent cells do not touch each other and also the cells at the periphery of the array may not extend fully to the outer edges of the front and back protective sheets. These outer edges and the space between the cells are the non-cell regions. When light is incident to the module, the non-cell region cannot convert radiant energy into electric power, which is a waste of energy.

A common method for increasing the efficiency and effectiveness of solar cell modules is to form geometrical features on the non-cell region. For example, International publication No. 2007/073203 (hereafter 203') describe that curves are formed in the transparent front protective sheet within a non-cell region to direct the light incident on the solar cell so that light does not fall on the non-cell region in the array. However, in the lamination process, high-indexed material, such as adhesive materials, may be coated onto the structured back-side of the transparent front sheet. This way, total internal reflection will not happen as it can only take place when light travels from a higher refractive index medium to a lower one.

Therefore, one aspect of the invention is to provide a solar cell module which can solve the problem mentioned above.

As will be seen more clearly from the detailed description below, the solar cell module includes : a back plate having at least one cell region and a non-cell region, at least one solar cell positioned within the cell region, an encapsulant encapsulating the solar cell, a cover plate laminated on the back plate and at least one hermetic chamber in the cover plate, wherein the hermetic chamber corresponds to the non-cell region, and the encapsulant is positioned between the cover plate and back plate.

A method of fabricating a solar cell module includes: providing a cover plate including a front surface and a back surface, and at least one trench formed in the back surface of the cover plate. Then, the at least one trench is covered with a sealing layer. Subsequently, a first adhesive layer is positioned on the back surface of the cover plate. Later, at least one solar cell is arranged on the first adhesive layer, wherein the at least one trench is positioned adjacent to the at least one solar cell. Next, a second adhesive layer is positioned on the at least one solar cell and on the first adhesive layer. Subsequently, a back plate is provided on the second adhesive layer. Finally, the cover plate, the sealing layer, the first and second adhesive layers and the back plate are laminated and form a hermetic chamber in the cover plate by fixing the sealing layer on an opening of the trench.

In the following, the invention is further illustrated by way of example, taking reference to the following drawings. Thereof:

FIG. 1 to FIG. 4 are schematic diagrams depicting a method of fabricating a solar module according to a preferred embodiment of the present invention; and
FIG. 5 is a schematic diagram depicting a solar cell module according to a preferred embodiment of the present invention.

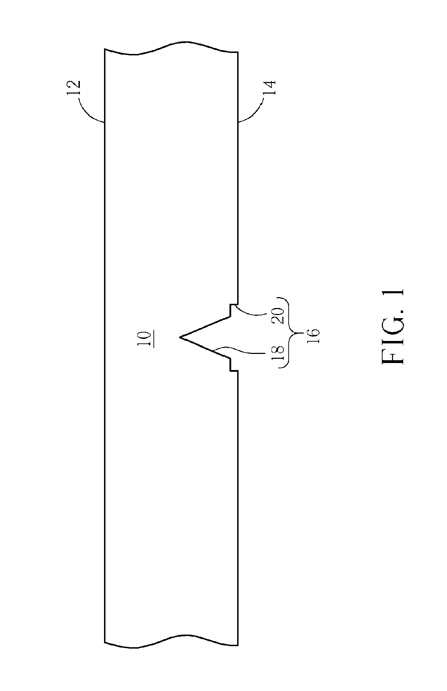

FIG. 1 to FIG. 4 are schematic diagrams depicting a method of fabricating a solar module according to a preferred embodiment of the present invention.

As shown in FIG. 1, first, a cover plate 10 including a front surface 12 and a back surface 14 is provided. At least one trench 16 is formed in the back surface 14. The cover plate 10 may be made of transparent material such as glass. Such cover plate 10 with the trench 16 in its back surface 14 may be made by a molding process. The method of forming the trench 16 is not limited to the aforesaid molding process. It is understood that other fabricating processes such as scratching or any possible process of shaping the cover plate can be applied according to the present invention.

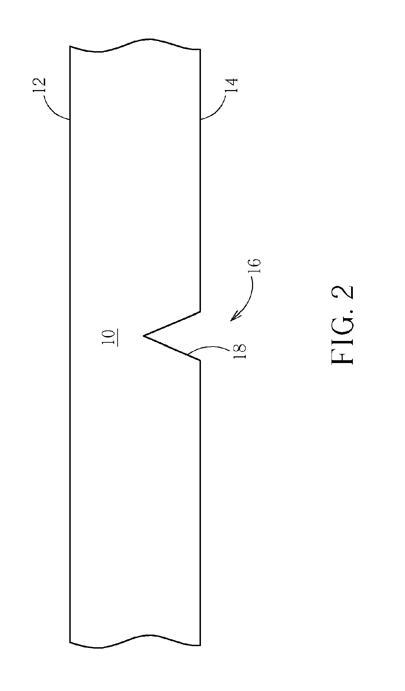

As set forth in FIG. 1, the trench 16 may include a V-shaped groove 18 which diverges toward the back surface 14. Furthermore, the trench 16 can optionally include a wide opening 20 in a U-shape for receiving a sealing layer, which will be described in the following description. FIG. 2 shows the trench 16 without the wide opening according to another preferred embodiment of the present invention. However, the trench 16 is not limited to a V-shape; other shapes such as segments of spherical, elliptical, parabolic geometries or other shapes can be applied according to the present invention.

In the following description, the trench 16 will be shown as including a V-shaped groove 18 with a wide opening 20.

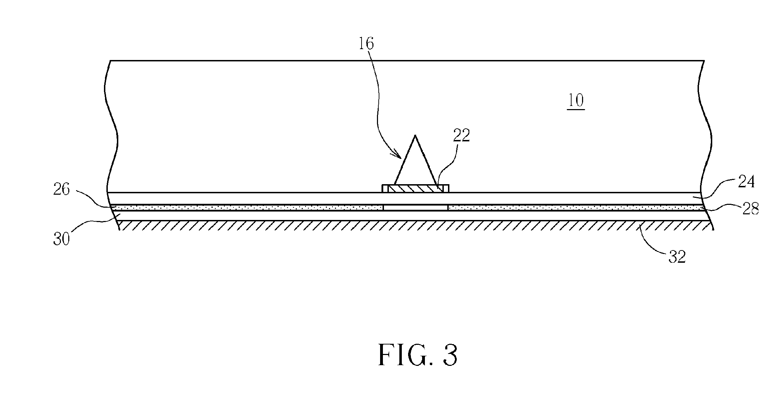

As shown in FIG. 3, a sealing layer 22 is disposed on the wide opening 20. In the case of FIG. 2, the sealing layer 22 will be disposed across the opening of the V-shaped groove 18 and on a part of the back surface 14 of the cover plate 10.

Please refer to FIG. 3. an adhesive layer 24 such as ethylene-vinyl acetate polymer (EVA) is formed on the back surface 14 of the cover plate 10 and on the sealing layer 22. Thereafter, a plurality of solar cells 26, 28 are arranged on the adhesive layer 24 and adjacent to the sealing layer 22. In other words, after the arrangement of solar cells 26, 28, the trench 16 covered by the sealing layer 22 is disposed between the solar cells 26, 28. Later, an adhesive layer 30 is formed on solar cells 26, 28 and on the adhesive layer 24. Subsequently, a back plate 32 is disposed on the adhesive layer 30.

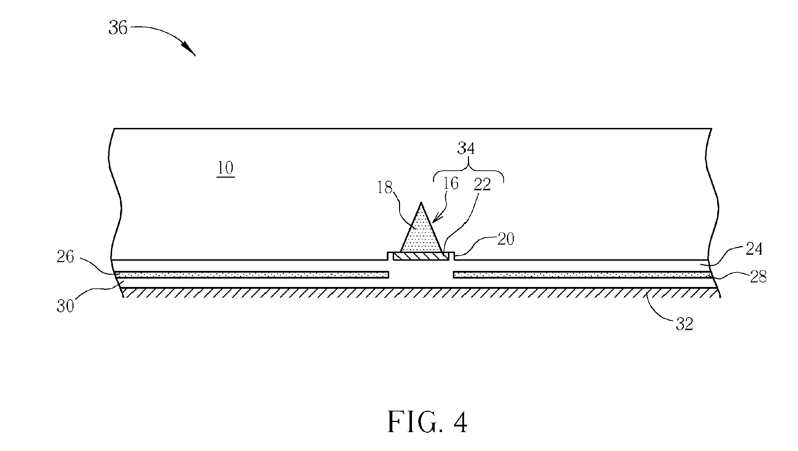

As shown in FIG. 4, the stack of the cover plate 10, the sealing layer 22, the adhesive layers 24, 30, solar cells 26, 28, and the back plate 32 is sent into a laminating apparatus (not shown). In the laminating apparatus, the stack is subjected to heat and can be pressed under a low pressure environment or in a vacuum environment, whereby the adhesive layers 24, 30 are melted. At the same moment, the air in the trench 16 is drawn out and the sealing layer 22 is attached on the wide opening 20 of the trench 16. After the laminating apparatus cools down the relative position of the cover plate 10, the sealing layer 22, solar cells 26, 28, and the back plate 32 is fixed by the adhesive layers 24, 30, and the sealing layer 22 is fixed on the wide opening 20 of the trench 16 as well. Therefore, the trench 16 sealed by the sealing layer 22 becomes a hermetic chamber 34, which means an empty space secures against the entry of water, vapor or other unwanted substances. At this point, the solar cell module 36 of the present invention is completed. Since the lamination process is performed under a low pressure environment or in a vacuum environment, the hermetic chamber 34 may have little air inside or may be a vacuum or near vacuum. Furthermore, adhesive layer generally contains curing agent. The lamination process is performed at a temperature higher than the curing temperature of the adhesive layers 24, 30. In order to prevent the melted adhesive layer 24 from flowing into the hermetic chamber 34, the sealing layer 22 must maintain its original shape during lamination. Therefore, the glass transition temperature (Tg) or the melting point of the sealing layer 22 should be higher than the laminating temperature. According to a preferred embodiment of the present invention, the adhesive layers 24, 30 is made of EVA, and the curing temperature of EVA is generally higher than 135°C. Accordingly, the sealing layer 22 can be made of polycarbonate, glass, ceramic, metal films, etc.

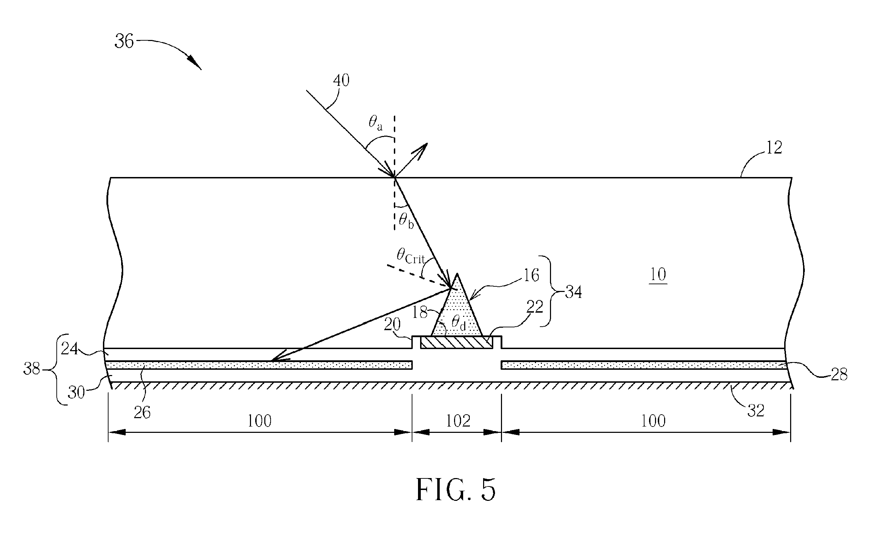

FIG. 5 is a schematic diagram depicting a solar cell module according to a preferred embodiment of the present invention, wherein like numerals designate like components. As shown in FIG. 5, a solar cell module 36 includes a back plate 32 including a plurality of cell regions 100 and a non-cell region 102. The solar cells 26, 28 are positioned within cell regions 100 respectively. It is noted that solar cells are only positioned on the cell regions 100; there is no solar cell within the non-cell region 102. A cover plate 10 is laminated on the back plate 32 and at least one hermetic chamber 34 is provided in the cover plate 10. The hermetic chamber 10 is disposed correspondingly to the non-cell region 102. An encapsulant 38 such as adhesive layer 24 or adhesive layer 30 for adhering the cover plate 10 and the back plate 32 encapsulates the solar cells 26, 28 and is disposed between the cover plate 10 and the back plate 32. The hermetic chamber 34 may be formed by a trench 16 inlaid in the cover plate 10 with a sealing layer 22 that seals a wide opening 20 of the trench 16. The trench 16 can be a V-shaped groove 18 diverging towards the back surface 14 as shown in FIG. 2 or a V-shaped groove 18 diverging toward the back plate 32 with the wide opening 20 in a U-shape as shown in FIG. 5. However, the trench 16 is not limited to a V-shaped groove; other shapes of grooves, other shapes such as segments of spherical, elliptical, parabolic geometries or other shapes can be applied in the present invention.

Still referring to FIG. 5, the hermetic chamber 34 may be in a shape of a prism, a triangular prism or other polyhedron prisms or in a shape of a semi-cylinder. The hermetic chamber 34 in the present invention refers to a space secured against the entry of water, vapor or other unwanted substances. The hermetic chamber 34 may be a vacuum chamber or an air chamber, with a refractive index of 1 or near 1.

The sealing layer is also preferably weather resistant and moisture resistant. As shown in FIG. 5, light 40 incidents on the front surface 12 of the cover plate 10 at a first angle $\theta_a$ are refracted and entering the cover plate 10 at a second angle $\theta_b$. The refracted light 40 then strikes the surface of the hermetic chamber 34 at a critical angle $\theta crit$ to the normal. After that, the light 40 will be reflected totally toward the solar cell 26. The side angle of the hermetic chamber 34 is marked as $\theta_d$. The relation between the first angle $\theta_a$, and the side angle $\theta_d$ can be derived by Snell's law, which is illustrated as follows.

$$n_a \sin\theta_a = n_b \sin\theta_b \qquad (1)$$

$$\theta_b = \arcsin\left(\frac{n_a}{n_b}\sin\theta_a\right) \qquad (2)$$

$$\theta_{crit} = \arcsin\left(\frac{n_a}{n_b}\right) \qquad (3)$$

$$\theta_d = \theta_b + \theta_{crit} = \arcsin\left(\frac{n_a}{n_b}\sin\theta_a\right) + \arcsin\left(\frac{n_a}{n_b}\right) \qquad (4)$$

Wherein $n_a$ is the refractive index of air or vacuum, which is equal to 1. $n_b$ is the refractive index of the cover plate 10.

If the cover plate 10 is made of glass, $n_b$ is about 1.5.

According to a preferred embodiment of the present invention, the side angle $\theta_d$ is about 70° and first angle $\theta_a$ is about 45°. That is, if the light 40 strikes the front surface 12 of the cover plate 10 with angles less than or equal to 45°, then the light 40 will be totally reflected when the light 40 strikes the surface of the hermetic chamber 34. It should be noted that the incident light 40 is subjected to single total reflection before reaches the surface of the solar cell 26. Therefore, energy of the light is saved.

It is noted that two solar cells and two cell regions are shown in the above embodiment. However, the solar cell module of the present invention can have other numbers of solar cells and cell regions. For example, the solar cell module can have only one solar cell positioned on one cell region.

For completeness, various aspects of the invention are set out in the following numbered clauses:

Clause 1: A solar cell module, comprising: a back plate having thereon at least one cell region and a non-cell region; at least one solar cell positioned within the cell region; a cover plate laminated on the back plate; and at least one hermetic chamber in the cover plate, wherein the hermetic chamber corresponds to the non-cell region.

Clause 2: The solar cell module of clause 1, wherein the hermetic chamber is a vacuum chamber.

Clause 3: The solar cell module of clause 1, wherein the hermetic chamber is an air chamber.

Clause 4: The solar cell module of clause 1, wherein the hermetic chamber is in a shape of a prism.

Clause 5: The solar cell module of clause 1, wherein the hermetic chamber is in a shape of a triangular prism.

Clause 6: The solar cell module of clause 1, wherein the hermetic chamber is defined by a V-shaped groove embedded in the cover plate and a sealing layer seals an opening of the V-shaped groove.

Clause 7: The solar cell module of clause 6, wherein V-shaped groove is embedded in a back surface of the cover plate, and the opening of the V-shaped groove faces toward the at least one solar cell.

Clause 8: The solar cell module of clause 6, wherein a melting point of the sealing layer is higher than a laminating temperature of the solar cell module.

Clause 9: The solar cell module of clause 6, wherein a glass transition temperature of the sealing layer is higher than a laminating temperature.

Clause 10: The solar cell module of clause 6, wherein the sealing layer is selected from the group consisting of plastic, glass, ceramic and metal films.

Clause 11: The solar cell module of clause 1, wherein an incident light that hits a surface of the hermetic chamber is totally reflected toward the at least one solar cell.

Clause 12: The solar cell module of clause 1, wherein the solar cell module further comprises an encapsulant encapsulating the at least one solar cell, wherein the encapsulant is sandwiched between the back plate and the cover plate.

Clause 13: A method of fabricating a solar cell module, comprising: providing a cover plate including a front surface and a back surface, and at least one a trench formed in the back surface of the cover plate; covering an opening of the trench with a sealing layer; arranging at least one solar cell on the back surface of the cover plate, wherein the trench is positioned adjacent to the at least one solar cell; providing a back plate on the sealing layer and the at least one solar cell; and performing a laminating process to laminate the at least one solar cell between the cover plate and the back plate, and laminate the sealing layer on the opening of the trench to form a hermetic chamber in the cover plate.

Clause 14: The method of fabricating a solar cell module of clause 13, wherein the laminating process is performed at a laminating temperature, and a melting point of the sealing layer is higher than the laminating temperature.

Clause 15: The method of fabricating a solar cell module of clause 14, wherein a glass transition temperature of the sealing layer is higher than the laminating temperature.

Clause 16: The method of fabricating a solar cell module of clause 13, wherein the sealing layer is selected from the group consisting of PET, PP, glass ceramic and metal films.

Clause 17: The method of fabricating a solar cell module of clause 13, wherein the trench is V-shaped, diverges toward the back surface of the cover plate, and the opening of the trench faces the solar cell.

Clause 18: The method of fabricating a solar cell module of clause 13, further comprising: before arranging the at least one solar cell, forming a first adhesive layer on the back surface of the cover plate.

Clause 19: The method of fabricating a solar cell module of clause 18, further comprising; after arranging the at least one solar cell, forming a second adhesive layer on the at least one solar cell and on the first adhesive layer.

Clause 20: The method of fabricating a solar cell module of clause 13, wherein the cover plate, the sealing layer, and the back plate are laminated in vacuum environment.

Clause 21: The method of fabricating a solar cell module of clause 13, wherein the hermetic chamber is a vacuum chamber.

Clause 22: The method of fabricating a solar cell module of clause 13, wherein the hermetic chamber is an air chamber.

Clause 23: The method of fabricating a solar cell module of clause 13, wherein an incident light entering from the front surface of the cover plate is totally reflected by a surface of the hermetic chamber and is directed toward the at least one solar cell.

Thus it has been shown that the solar cell module of the present invention is capable of collecting the light through the total reflection by the hermetic chamber. The hermetic chamber is an empty space in the cover plate which does not allow foreign bodies to get in or out. Since the hermetic chamber is disposed on the non-cell region, light striking on the non-cell region can be directed toward the cell region by the hermetic chamber.

All combinations and sub-combinations of the above-described features also belong to the invention.

Claims

1. A solar cell module (36), **characterized by**:

   a back plate (32) having thereon at least one cell region (100) and a non-cell region (102);
   at least one solar cell (26, 28) positioned within the cell region (100);
   a cover plate (10) laminated on the back plate (32); and
   at least one hermetic chamber (34) in the cover plate (10), wherein the hermetic chamber (34) corresponds to the non-cell region (102).

2. The solar cell module (36) of claim 1, **characterized in that** the hermetic chamber (34) is a vacuum chamber.

3. The solar cell module (36) of claim 1, **characterized in that** the hermetic chamber (34) is an air chamber.

4. The solar cell module (36) of claim 1, **characterized in that** the hermetic chamber (34) is in a shape of a prism.

5. The solar cell module (36) of claims 1, 2, 3, or 4, **characterized in that** the hermetic chamber (34) is defined by a V-shaped groove (18) embedded in the cover plate (10) and a sealing layer (22) seals an opening (20) of the V-shaped groove (18).

6. The solar cell module (36) of claim 5, **characterized in that** a melting point of the sealing layer (22) is higher than a laminating temperature of the solar cell module (36) .

7. The solar cell module (36) of claim 5, **characterized in that** the V-shaped groove (18) is embedded in a back surface (14) of the cover plate (10), and the opening of the V-shaped groove (18) faces toward the solar cell (26, 28).

8. The solar cell module (36) of claim 1, **characterized in that** an incident light (40) that hits a surface of the hermetic chamber (34) is totally reflected toward the at least one solar cell (26, 28).

9. The solar cell module (36) of claim 1, **characterized in that** the solar cell module (36) further comprises an encapsulant (38) encapsulating the at least one solar cell (26, 28), wherein the encapsulant (38) is sandwiched between the back plate (32) and the cover plate (10).

10. A method of fabricating a solar cell module (36), **characterized by**:

    providing a cover plate (10) including a front surface (12) and a back surface (14), and at least one trench (16) formed in the back surface (14) of the cover plate (10);
    covering an opening of the trench (16) with a sealing layer (22);
    arranging at least one solar cell (26, 28) on the back surface (14) of the cover plate (10), wherein the trench (16) is positioned adjacent to the at least one solar cell (26, 28);
    providing a back plate (32) on the sealing layer (22) and the at least one solar cell (26, 28); and
    performing a laminating process to laminate the at least one solar cell (26, 28) between the cover plate (10) and the back plate (32), and laminate the sealing layer (22) on the opening (20) of the trench (16) to form a hermetic chamber (34) in the cover plate (10).

11. The method of fabricating a solar cell module (36) of claim 10, **characterized in that** the laminating process is performed at a laminating temperature, and a melting point of the sealing layer (22) is higher than the laminating temperature.

12. The method of fabricating a solar cell module (36) of claim 10, **characterized in that** the trench (16) includes a V-shaped groove (18), which diverges toward the back surface (14) of the cover plate (10), and the opening (20) of the trench (16) faces the at least one solar cell (26, 28).

13. The method of fabricating a solar cell module (36) of claim 10, further **characterized by**:

    before arranging the at least one solar cell (26, 28), forming a first adhesive layer (24) on the back surface (14) of the cover plate (10); and
    after arranging the at least one solar cell (26, 28),forming a second adhesive layer (30) on the at least one solar cell (26, 28) and on the first adhesive layer (24).

**14.** The method of fabricating a solar cell module (36) of claim 10, **characterized in that** the hermetic chamber (34) is a vacuum chamber.

**15.** The method of fabricating a solar cell module (36) of claim 10, **characterized in that** the hermetic chamber (34) is an air chamber.

EP 2 395 557 A2

FIG. 1

FIG. 2

FIG. 3

FIG. 4

FIG. 5

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2007073203 A